# EUROPEAN PATENT SPECIFICATION

(11) **EP 3 538 480 B1**
(45) Date of publication and mention of the grant of the patent: **28.10.2026**
(21) Application number: 17868755.4
(22) Date of filing: 10.11.2017
(51) Int. Cl.: G01C 19/5733, B81B 3/00, B81B 7/02, G01P 15/00, B81B 7/00, G01P 15/097, G01P 15/125

(54) **VERTICAL STOPPER FOR CAPPING MEMS DEVICES**
VERTIKALER STOPFEN ZUM VERSCHLIESSEN VON MEMS-VORRICHTUNGEN
DISPOSITIF D'ARRÊT VERTICAL SERVANT À COUVRIR DES DISPOSITIFS DE MEMS

(30) Priority: 11.11.2016 US 201662420893 P; 14.07.2017 US 201715650822
(43) Date of publication of application: 18.09.2019
(73) Proprietor: Analog Devices, Inc., Wilmington, MA 01887 (US)
(72) Inventor: KUANG, Jinbo, Acton, MA 01720 (US); VOHRA, Gaurav, Sudbury, MA 01776 (US)
(74) Representative: Halliwell, Bethan Frances
(86) International application number: PCT/US2017/061001
(87) International publication number: WO 2018/089733

(56) References cited:
- EP-A2- 1 947 053
- EP-A2- 1 950 174
- EP-A2- 2 390 671
- EP-A2- 2 453 570
- EP-A2- 2 759 802
- WO-A1-99/42843
- US-A- 5 415 726
- US-A1- 2010 089 153
- US-A1- 2012 125 104
- US-A1- 2013 020 693
- US-A1- 2015 048 903
- US-A1- 2015 260 517
- US-B1- 9 206 032
- KAINZ A ET AL: "Air damping as design feature in lateral oscillators", SENSORS AND ACTUATORS A: PHYSICAL, vol. 236, 1 December 2015 (2015-12-01), pages 357 - 363, XP029360011, ISSN: 0924-4247, DOI: 10.1016/J.SNA.2015.11.005

## Description

### CROSS REFERENCE TO RELATED APPLICATIONS

This application claims the benefit under 35 U.S.C. §119(e) of U.S. Provisional Patent Application Serial No. 62/420,893, filed on November 11, 2016 under Attorney Docket No. G0766.70133US00 and entitled "Vertical Stopper For Capping MEMS Devices,".

This application is a continuation claiming the benefit under 35 U.S.C. §120 of U.S. Pat. App. Serial No. 15/650,822, filed on July 14, 2017 under Attorney Docket No. G0766.70133US01 and entitled "Vertical Stopper For Capping MEMS Devices". U.S. Pat. App. Serial No. 15/650,822 claims the benefit under 35 U.S.C. §119(e) of U.S. Provisional Patent Application Serial No. 62/420,893, filed on November 11, 2016 under Attorney Docket No. G0766.70133US00 and entitled "Vertical Stopper For Capping MEMS Devices",

### FIELD OF THE DISCLOSURE

The present application relates to capping technology for capping microelectromechanical systems (MEMS) devices.

### BACKGROUND

Some microelectromechanical systems (MEMS) devices include a movable proof mass. Examples are resonators, accelerometers, and gyroscopes. The proof mass may be formed on one substrate, or wafer, referred to as a MEMS wafer. A capping structure is sometimes bonded to the MEMS wafer to form a sealed enclosure around the proof mass.
US 9 206 032 B 1 describes a MEMS device with a movable structure and a cap comprising a stopper coupled to the cap through an elastic structure, the stopper arranged to constrain a movement of a movable structure.
WO 99/42843 A1 describes a semiconductor acceleration sensor which comprises a middle substrate with a center contact , and outer substrates, at least one of which has an outer
contact and wherein the middle substrate (1) includes a weight close to the center contact, while the outer substrate, having the outer contact, includes a counterpart facing the weight, so that a squeezed damping effect is obtained.
US 2013/020693 A1 describes a chip package structure comprising an inertial object and a block disposed and corresponding to the inertial object 210 for limiting the movement of the inertial object 210 in a direction perpendicular to the surface of the wafer of the package structure.
EP 2 390 671 A2 describes a physical quantity sensor that includes a first rocking body and a second rocking body wherein each of the rocking bodies is supported on a substrate by respective first supporting portion and a second supporting portion.
Kainz A et al. "Air damping as design feature in lateral oscillators", Sensors and Actuators A: Physical, vol. 236, pages 357-363, XP029360011, describes a MEMS system comprising an optical vibration sensor, wherein an array of rectangular holes is positioned over another similar array to create a grid of apertures. This grid of apertures is then positioned on top of a photoresistor which produces a current based on the light passing through the apertures to reach the photoresistor.
US 2010/089153 describes encapsulated devices comprising a bottom substrate, a middle substrate that is disposed above the bottom substrate, and a top substrate that is disposed above the middle substrate. The middle substrate comprises an outermost structure and at least one damping device. At least one top gap and a bottom gap are formed between the at least one damping device and the top and bottom substrates, respectively. The at least one top gap has at least one cavity depth that is adapted to adjust the damping level of the encapsulated device.
EP 2759802 describes a multi-axis integrated MEMS inertial sensor device including an integrated 3-axis gyroscope and 3-axis accelerometer on a single chip, creating a 6-axis inertial sensor device. The device is provided with a Z travel stop structure in a cap wafer to adjust damping performance in the central area of the chip, where the accelerometer device is disposed.

### SUMMARY OF THE DISCLOSURE

Capped microelectromechanical systems (MEMS) devices are described. In some situations, the MEMS device includes one or more masses which move. The cap may include a stopper which damps motion of the one or more movable masses. In some situations, the stopper damps motion of one of the masses but not another mass.

According to one aspect of the present application, a method of operating a microelectromechanical systems (MEMS) device sealed in a cap that comprises a stopper according to claim 1 is provided.

According to another aspect of the present application, a MEMS device is provided according to claim 3.

### BRIEF DESCRIPTION OF THE DRAWINGS

Various aspects and embodiments of the application will be described with reference to the following figures. It should be appreciated that the figures are not necessarily drawn to scale. Items appearing in multiple figures are indicated by the same reference number in all the figures in which they appear.
FIG. 1A is a schematic diagram illustrating a microelectromechanical systems (MEMS) device comprising a proof mass sealed in a cap that comprises a stopper, for facilitating understanding of the claimed invention.
FIG. 1B is a cross-sectional view of the MEMS device in FIG.1A along the dashed line 1B.
FIG. 2 is a flowchart illustrating a method of operating a MEMS device described herein, according to some non-limiting embodiments for facilitating understanding of the claimed invention.
FIG. 3A is a schematic diagram illustrating a MEMS device comprising a proof mass sealed in a cap that comprises a stopper overlying an internal edge of the proof mass, for facilitating understanding of the claimed invention.
FIG. 3B is a cross-sectional view of the MEMS device in FIG.3A along the dashed line 3B.
FIG. 3C is a schematic diagram of an alternative to FIG. 3A in which the stopper has a hole therein.
FIG. 4 is a top view illustrating a MEMS device comprising a proof mass sealed in a cap that comprises a stopper overlying a majority of the proof mass but not a sense finger, for facilitating understanding of the claimed invention.
FIG. 5A is a schematic diagram illustrating a MEMS device comprising a proof mass sealed in a cap that comprises a stopper according to the invention.
FIG. 5B is a schematic diagram illustrating a MEMS double mass gyroscope sealed in a cap that comprises a stopper for each of the two proof masses, according to some non-limiting embodiments.
FIG. 5C is a schematic diagram illustrating a MEMS double mass gyroscope sealed in a cap that comprises a single stopper covering both proof masses, according to some non-limiting embodiments.
FIG. 5D is a schematic diagram illustrating a MEMS quadruple (quad) mass gyroscope sealed in a cap that comprises a stopper for each of the four proof masses, according to some non-limiting embodiments.
FIG. 5E is a schematic diagram illustrating a MEMS quadruple (quad) mass gyroscope sealed in a cap that comprises a single stopper covering the four proof masses, according to some non-limiting embodiments.
FIG. 6 is a block diagram illustrating a system comprising a MEMS device of the types descried herein, according to some non-limiting embodiments.
FIG. 7 illustrates a vehicle comprising the system of FIG.6, according to some non-limiting embodiments.

### DETAILED DESCRIPTION

Aspects of the present application provide a capping structure for microelectromechanical systems (MEMS) devices in which the capping structure includes a stopper or protrusion shaped and positioned to damp motion of a capped MEMS component. In some embodiments, the stopper of the cap aligns with a proof mass oscillating in an in-plane mode on a MEMS wafer being capped. The stopper is shaped and positioned to overlie regions through which gas flows when the MEMS component moves, thus providing damping functionality by preventing, redirecting, or otherwise impeding such gas flow. For example, in some embodiments the stopper overlies a periphery of the mode shape of one of the movable proof mass and/or internal edges of the movable proof mass. The stopper may be aligned with one of the movable proof mass and have a surface area greater than 50% of the movable proof mass, between 60% and 130% the area of the movable proof mass, or any value within those ranges.

Some MEMS devices include a movable proof mass suspended above a surface of a wafer and retained with beams that serve as elastic springs. A quality factor (Q) may be defined to describe the qualitative behavior of the oscillation of a movable proof mass, and may represent a comparison of the frequency bandwidth of the MEMS component relative to its center frequency. Higher Q indicates a lower rate of energy loss relative to the stored energy of the movable proof mass. Q with different values may be desired depending on the specific systems and applications. The inventors have recognized and appreciated that the configuration of the capping structure allows control of the Q of a movable proof mass.

According to an example not part of the invention to facilitate understanding of the present application, the MEMS device may be a resonator having a movable proof mass sealed by a capping structure with a stopper. The stopper is proximate, but spaced apart from the movable proof mass which it overlies. The movable proof mass is configured to move in-plane, with the stopper being disposed out of the plane. The stopper performs a damping function by limiting the volume of the sealed enclosure, thus limiting the potential displacement of gas within the enclosure when the proof mass moves. Therefore, the Q of the resonator may be controlled by designing the stopper to provide a target degree of damping, which may be regulated by the placement and/or surface area of the stopper relative to the movable proof mass, and/or the distance of the gap between the stopper and the movable proof mass.

According to another aspect of the present application, not part of the invention the MEMS device may be an accelerometer having a resonator and one or more sense fingers sealed by a capping structure having a stopper. The stopper may be sized to overlie the resonator but not the sense fingers such that the effect of the damping may be reduced or minimized on the sense fingers' response to the force exerted by the movable proof mass of the resonator. The accelerometer may include at least two resonators (e.g., a differential accelerometer) that are aligned with and underlie the stopper.

The MEMS device may be a gyroscope having a resonator and an accelerometer sealed by a capping structure having a stopper. The stopper may overlie the resonator but not the accelerometer to any significant degree. Such a configuration may damp motion of the resonator more than that of the accelerometer, and in this respect may be said to provide selective damping. As a result, this configuration may allow separate control of the resonator Q and the accelerometer Q. The resonator Q may be comparable to that which would be achieved with a sealed enclosure at greater pressure, thus allowing the use of a lower pressure to attain a higher accelerometer Q while maintaining the same resonator Q. This configuration may also reduce the electrical coupling from the resonator to the sense fingers of the accelerometer because the damping stopper may act as a shield.

The gyroscope may include a movable Coriolis proof mass and at least two resonators sealed by a capping structure having a stopper. Mismatches of the motion of the at least two resonators may cause phase dispersion, resulting offset, gee-sensitivity and coupling of energy between the gyroscope and the packaging. Lower Q of the resonators may reduce such effect. However, lower Coriolis Q causes higher gyroscope noise. Thus, the inventors have recognized that in at least some embodiments including a resonator and a Coriolis proof mass, it may be desirable to lower the Q of the resonator(s) but not the Coriolis proof mass. Accordingly, the stopper may overlie the at least two resonators but not the movable Coriolis proof mass such that the resonator Qs are reduced substantially compared to a scenario in which no stopper is provided while the Coriolis Q is at most slightly decreased. Such a configuration may facilitate use of a lower capping pressure to provide the same resonator Q as would be achieved without a damping stopper, while providing an increased Coriolis Q. This configuration may also reduce the electrical coupling from the resonators to the Coriolis electrodes.

The aspects and embodiments described above, as well as additional aspects and embodiments, are described further below. These aspects and/or embodiments may be used individually, all together, or in any combination of two or more, as the application is not limited in this respect.

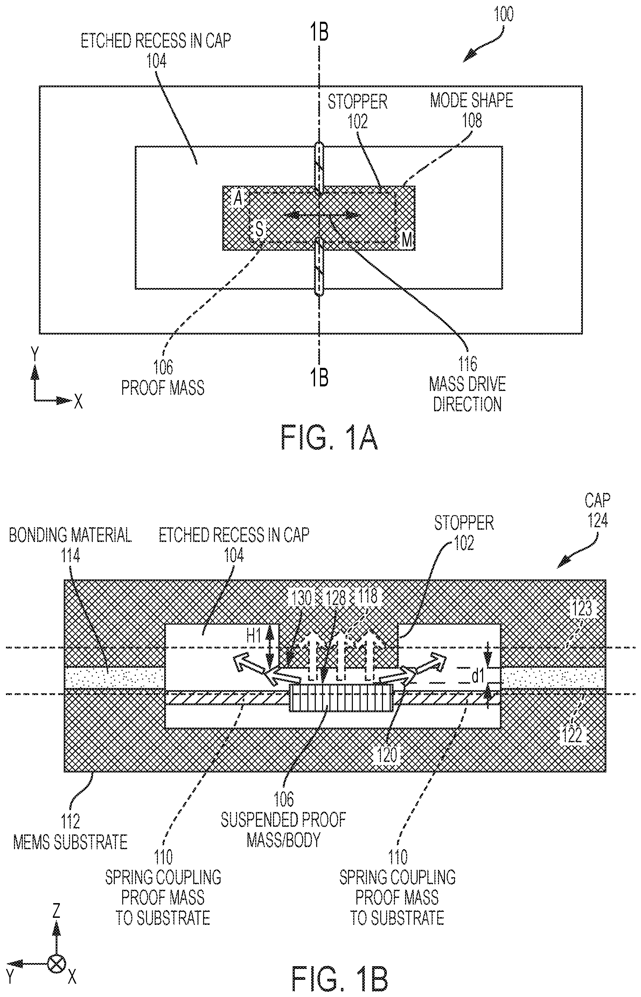

FIG. 1A illustrates in top view multiple superimposed planes of a microelectromechanical systems (MEMS) device 100 having a damping stopper overlying a movable proof mass, according to a an example to facilitate understanding of the application that is not an embodiment of the claimed invention. FIG.1B illustrates a cross-sectional view of the MEMS device 100 along the dashed line 1B of FIG. 1A. FIG. 1A shows a superposition of the planes along the lines 122 and 123 of FIG. 1B-that is, FIG. 1A illustrates a plane though the cap superimposed on a plane though the MEMS substrate.

The MEMS device 100 includes a MEMS substrate 112 sealed by a cap 124 with a bonding material 114. The MEMS substrate 112 may include a movable proof mass 106 suspended above a cavity by springs 110. The cap 124 includes a stopper 102 positioned to overlie the movable proof mass 106, and in the illustrated example has a proximate to and parallel to the proof mass 106 with a surface area greater than that of a surface of the proof mass proximate to and parallel with the stopper.

The MEMS substrate 112, which may be a wafer in some embodiments or alternatively a diced chip in other embodiments, may include a suspended proof mass 106 and springs (or "tethers") 110 that couple the proof mass to the MEMS substrate 112. In this manner, the proof mass 106 may be suspended above a cavity in the MEMS substrate 112. The MEMS substrate 112 may be formed of silicon, or more generally a semiconductor material, or any other suitable material. The proof mass 106 and springs 110 are formed of the same material in some non-limiting embodiments, for example being etched from the MEMS substrate 112. However, in other embodiments the proof mass and springs may be formed of different materials, or at least different stacks of materials.

FIG. 1A illustrates an outline of the proof mass 106 in dashed lining. The proof mass 106 may be suspended from the MEMS substrate 112 by the springs 110 in a configuration allowing motion of the proof mass along the direction 116 shown in FIG. 1A. For example, the proof mass may be a resonator driven along the direction 116. Alternatively, the proof mass may be part of an accelerometer, allowed to move along the direction 116 in response to experiencing acceleration. Irrespective of the type of proof mass employed, the movement of the proof mass may define a mode shape, illustrated in FIG. 1A as mode shape 108. In the illustrated example, the mode shape 108 may have a planar area ***M*** of a greater lateral extent in the x-direction than the proof mass 106, meaning the proof mass 106 may move from its equilibrium position in both the positive and negative x-direction. The illustrated mode shape is a non-limiting example, as other modes of vibration (or, more generally, motion) are possible. Also, depending on the type of MEMS device, additional structures may be included, such as electrodes on the proof mass 106, electrical connection traces, or other structures. These optional structures are omitted from the figure for simplicity of illustration.

The cap 124, which may be a semiconductor material or any other suitable material, may include a stopper 102 surrounded by a recess 104. The stopper may have a surface 130 with a surface area A facing the MEMS substrate 112. The recess 104 may be formed by etching, such that the stopper 102 may represent a protrusion, plateau, extension, bump, or other similar structure. The stopper 102 may be positioned in the central region of the cap 124 in some embodiments, although alternative positioning may be used in other embodiments. The cap may be a silicon wafer and the stopper may be formed by etching the silicon wafer. The depth of the recess 104 may be between 20 µm and 150 µm, including any value within that non-limiting range (e.g., 80 µm). The surface 130 of the stopper may be separated from the substantially parallel top surface 128 of the proof mass by a gap with a distance **d1.** The distance **d1** may be less than 20 µm in some examples, including any value within that non-limiting range (e.g., between 2 µm and 20 µm, or between 3 and 10 µm).

As described above, the present application provides a stopper of a cap for a MEMS device which operates as a damper. In the embodiments, then, the stopper is a damping stopper, performing the dual functions of damping motion of the proof mass and stopping motion of the proof mass from extending beyond an allowable limit. One or more features of the stopper may be selected to provide the damping functionality. For example, the stopper may be positioned to overlie a periphery of the mode shape of the proof mass. Considering FIGs. 1A and 1B as an example, the in-plane perimeter of the stopper 102 overlies the periphery of the mode shape 108. In some embodiments, the perimeter of surface 130 may extend beyond the periphery of the mode shape 108. For example, the surface area ***A*** of surface 130 may be greater than the area ***M*** of the mode shape 108. As the proof mass 106 moves it will push the surrounding gas, to the extent there is any, at its perimeter. Positioning the stopper 102 to overlie the periphery of the mode shape 108 may stop, redirect, or otherwise impede such flow of the gas, which will in at least some embodiments damp the motion of the proof mass 106.

In some embodiments, the damping functionality of a stopper of a cap for a MEMS device may be achieved by sizing the stopper to have a surface area representing a substantial percentage of the surface area of the underlying proof mass. Referring to FIGs. 1A and 1B, the surface area A may be selected to substantially correspond to the surface area ***S*** of the proof mass 106, for example being greater than 50% of ***S***. The surface area A may be between 75% and 125% of the area S of the surface 128 and/or area ***M*** of the mode shape 108, including any value within this range. Irrespective of whether the stopper overlies a periphery of the mode shape 108, the stopper 102 may damp motion of the proof mass 106 by limiting the volume of the sealed enclosure in which the proof mass is disposed, thus limiting the potential displacement of gas within the enclosure when the proof mass 106 moves. For example, some air would move in the direction of arrows 118 if stopper 102 was omitted or had a different shape/size; instead, the air is forced to move in the direction of arrows 120 because of the stopper. Therefore, the Q of the movable proof mass may be adjusted by the placement and/or surface area of the stopper relative to the movable proof mass, and/or the distance of the gap between the stopper and the movable proof mass.

The size of the gap **d1** may also be used to facilitate damping of the motion of proof mass 106. Making **d1** small serves to limit the volume of the enclosed cavity in which the proof mass 106 is disposed. Doing so, as described above, contributes to damping the in-plane motion of the proof mass 106. The value of **d1** may be any of the values described above.

Thus, features of the stopper 102 including the sizing, positioning relative to the proof mass 106, and distance **d1** from the proof mass be selected to facilitate the damping functionality of the stopper 102. In general, the stopper 102 surface 130 may have a rectangular shape, a ring shape, a discontinuous shape, or any other suitable shape. The surface 130 may have an area A sized according to any of the dimensions described above relative to the area ***S*** of the proof mass 106. The distance **d1** may be any of the values described above.

The bonding material 114 may be epoxy, glass frit, adhesive, eutectic bonding material, or any other suitable bonding material. The thickness of the bonding material may be in the range of 2 µm to 20 µm, for example being between 3 and 10 µm, including any value within those ranges. The bond may provide a hermetic seal.

The MEMS substrate 112 may be sealed by the cap 124 in an environment with a desired pressure/gas composition. In some embodiments, the structure of FIGs. 1A and 1B allows for achieving the same or higher device Q while sealing the device with a lower pressure than would result from a cap lacking a damping stopper. For example, in some embodiments the pressure may be between two to five times lower (e.g., 100 mbar instead of 300 mbar) when using a cap with a damping stopper of the types described herein, while providing the same Q of the MEMS device. Other pressure reductions are also possible.

While FIGs. 1A and 1B illustrate a single proof mass 106 and stopper 102, the various aspects described herein are not limited in this manner. As described above, the MEMS substrate 112 may be a wafer in some embodiments, as may be the cap 124. Thus, multiple proof masses 106 may be formed on the MEMS substrate 112 and capped, with respective stoppers 102 provided, and the resulted capped structure diced from the wafer.

In operation, the proof mass 106 may move, for example by oscillating, in the plane 122 along the direction 116. The motion may be damped by the presence of the stopper 102 in the manner described above. Moreover, should the proof mass move out-of-plane, in the z-direction, the stopper 102 may provide a limit to such motion.

Thus, according to an aspect of the present application, a method of operating a MEMS comprising a movable mass is provided. The method may comprise moving the movable mass in a planar in which the movable mass lies, and damping the motion of the movable mass using a damper or a damping stopper of a cap capping the MEMS device.

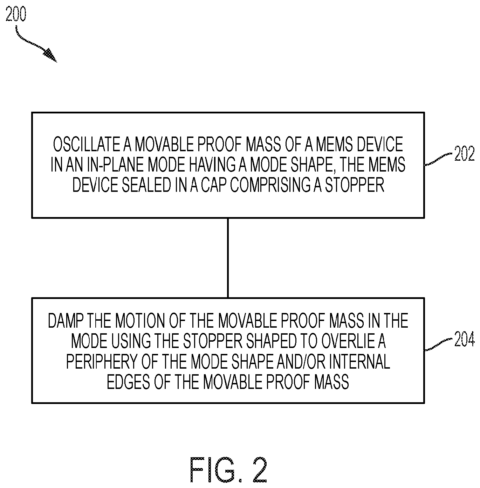

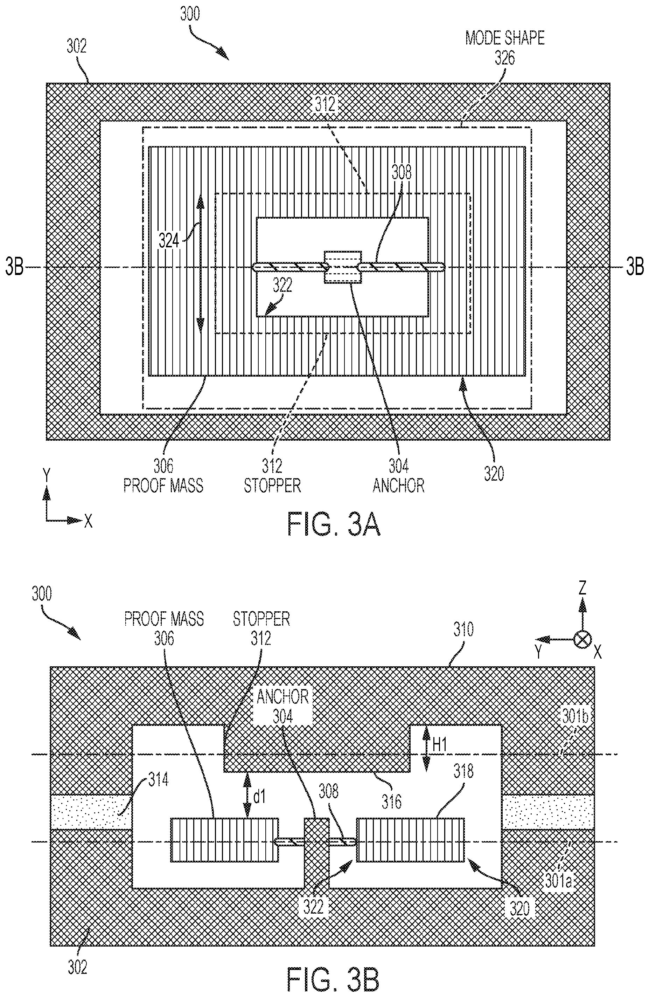

FIG. 2 illustrates such a method of operating a MEMS device described herein, according to an example that is excluded from the scope of the claims to facilitate understanding of the invention. Method 200 may begin at stage 202, in which a movable proof mass of a MEMS device may be oscillated in an in-plane mode having a mode shape, wherein the MEMS device may be sealed in a cavity capped by a cap comprising a stopper. At stage 204, the motion of the movable proof mass may be damped using the damper or damping stopper shaped to overlie a periphery of the mode shape and/or internal edges of the movable proof mass. It should be appreciated that, while stage 204 is illustrated as following stage 202, the two stages may occur simultaneously, or at substantially the same time, in some embodiments. That is, the damping may occur as the movable proof mass moves (e.g., oscillates). While FIGs. 1A-1B illustrate an example in which the stopper 102 overlies a periphery of a mode shape of the movable proof mass, other embodiments have a different configuration. As described above, the stopper of a MEMS cap may provide damping by overlying a perimeter of an underlying movable proof mass or the mode shape of the movable proof mass. However, some movable proof masses may have interior edges, and gas flow may occur in the vicinity of those edges when the proof mass moves. Thus, a damping stopper may damp motion of an underlying proof mass by overlying the interior edges of the movable proof mass. FIGs. 3A and 3B illustrate an example to facilitate understanding of the invention.

The MEMS device 300 may include a MEMS substrate 302, an anchor 304, a movable proof mass 306 suspended from the anchor 304 by tethers 308, and a cap 310 including a stopper 312. The cap 310 may be bonded to the MEMS substrate 302 by a bonding material 314. The stopper 312 may have a surface 316 facing and proximate a surface 318 of the proof mass 306. FIG. 3A is a top down view of multiple superimposed planes, corresponding to the planes 301a and 301b of FIG. 3B, and FIG. 3B is a cross-section of the device 300 along the line 3B in FIG. 3A.

The MEMS substrate 302 may be of the same type as MEMS substrate 112 previously described, or any other suitable MEMS substrate. The anchor 304 may be a projection from the MEMS substrate 302. The tethers 308 may be of the same type as springs 110 previously described, such as being straight beams or serpentine structures.

The proof mass 306 may be of any suitable size and shape. As illustrated, the proof mass 306 may have an outer boundary (or perimeter) or edge 320 and an inner boundary or edge 322. The tethers 308 may contact the inner edge. The proof mass 306 may be configured to move (e.g., vibrate or oscillate) in the xy-plane plane along the direction of arrow 324, defining a mode shape 326. Additional structures such as electrodes and electrical connections are omitted for simplicity of illustration.

The cap 310 may be of the same type as cap 124 previously described. The stopper 312 may have a height **H1** between 20 µm and 150 µm as a non-limiting example, including any value with that range. The surface 316 of the stopper 312 may be separated from the surface 318 of the proof mass 306 by the distance **d1,** having any of the values described previously in connection with FIGs. 1A-1B.

As can be seen in FIGs. 3A-3B, the perimeter of the stopper 312 overlies and is larger than the inner boundary 322 of the proof mass 306, while it does not extend to the outer boundary 320. As the proof mass 306 moves gas will be pushed at the inner boundary 322, and the positioning of the stopper 312 impedes (e.g., redirects that gas flow, thus damping motion of the proof mass 306. In an alternative embodiment not part of the invention, the surface 316 may have a sufficiently large area to overlie both the inner boundary 322 and the outer boundary 320.

The bonding material 314 may be the same type as those described previously in connection with bonding material 114 of FIGs. 1A-1B.

The MEMS device 300 may be operated in the manner of method 200 of FIG. 2. Other manners of operation are also possible.

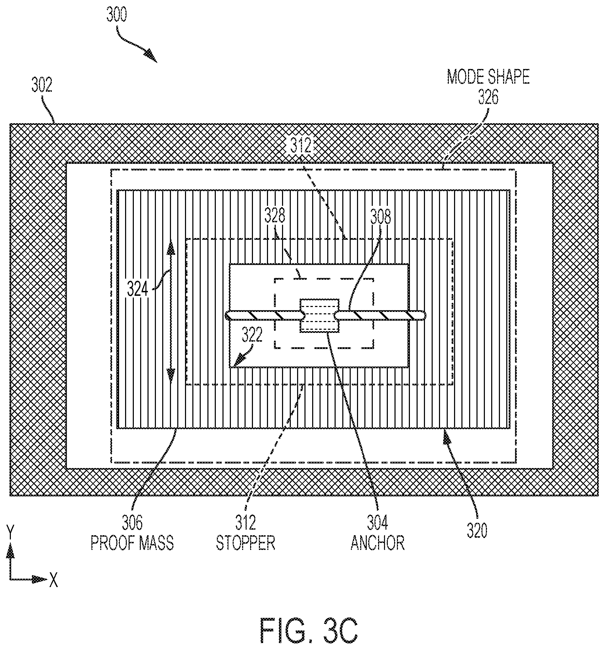

In some embodiments, the stopper itself may not have a continuous planar surface adjacent the proof mass. That is, surface 316 in FIG. 3B may not be continuous and/or planar. An example of an alternative is shown in FIG. 3C.

FIG. 3C illustrates an alternative to FIG. 3A in which the stopper itself includes a hole, or opening, therein. The hole is represented by dashed line 328. That is, the stopper surface adjacent the proof mass 306 may be between the dashed lines 312 and 328. Inside dashed line 328 the stopper may be recessed, for example by suitable etching. The recess or hole in the stopper may have any suitable size and/or positioning. Moreover, while a single hole is illustrated, multiple holes may be formed in the stopper, in any suitable arrangement. Thus, aspects of the present application provide a damping stopper with a non-planar surface adjacent the underlying proof mass.

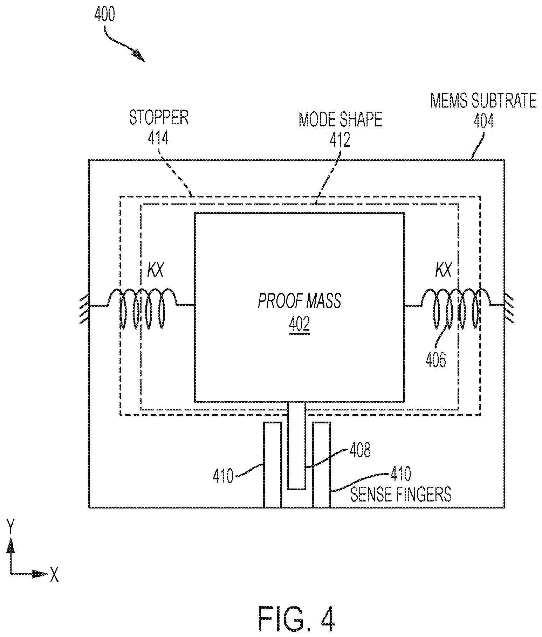

A damping stopper of a cap for a MEMS device may be positioned to substantially overlap a mode shape of an underlying movable proof mass, while not overlying one more drive and/or sense structures. Various types of MEMS devices, such as MEMS resonators, accelerometers, and gyroscopes, may have drive and/or sense structures, such as finger-like projections. For example, capacitive MEMS accelerometers may include a capacitive comb structure, in which motion of the proof mass changes a capacitance between the fingers coupled to the proof mass and stationary fingers coupled to the substrate. FIG. 4 illustrates a top view of an example of such a device to facilitate understanding of the invention.

The MEMS device 400 includes a proof mass 402 coupled to a MEMS substrate 404 by springs 406. The proof mass 402 includes a finger 408, while two stationary fingers 410 are fixed to the substrate MEMS substrate 404. For example, the stationary fingers 410 may project upward from the substrate to be in-plane with the finger 408 of the proof mass.

The proof mass 402 may move in the xy-plane in a manner defining a mode shape 412. The motion causes a change in distance between the finger 408 and the neighboring fingers 410. Thus, the values of the capacitances between those fingers may change, and the change may be detected, for example, to ascertain the motion of the proof mass 402.

A damping stopper 414, forming part of a capping to cap the MEMS device, may be positioned to overlie the proof mass 402. In the top down view of FIG. 4, the perimeter of the stopper is superimposed over the proof mass 402. As shown, the stopper 414 may be sized and positioned to substantially overlie the proof mass 402 and the mode shape 412. However, the stopper 414 does not overlie the fingers 408 or 410.

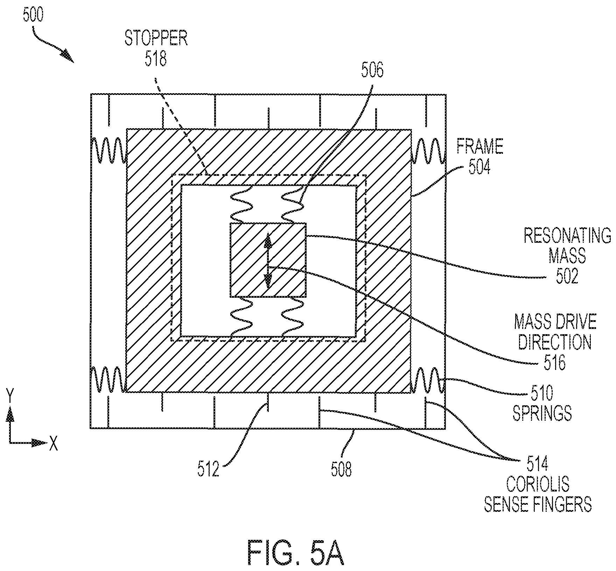

According to the invention, a damping stopper of a cap for a MEMS device is employed in MEMS devices having more than one moving mass, and provides selective damping of motion of the masses. An example MEMS device is a gyroscope, some of which have a resonating mass and an accelerating mass. In the case of a gyroscope, the resonating mass (or "resonator") may be driven in one direction, and the accelerating mass may move in response to the Coriolis force. A damping stopper is provided to selectively damp motion of one of the masses, such as the resonating mass. Non-limiting examples are illustrated in FIGs. 5A-5C.

FIG. 5A is a top view of a MEMS device 500 including a resonating mass 502 springedly coupled with a frame 504 by springs 506. The frame 504 may by coupled to a substrate 508 by springs 510. Sense fingers 512 are extend from the frame 504 and fingers 514 extend from the substrate 508. The sense fingers 512 and 514 may in combination form capacitances sensitive to motion of the frame 504 relative to the substrate 508.

In operation, the resonating mass 502 is driven to oscillate in the xy-plane along the y-direction as illustrated by the arrow 516. Rotation of the MEMS device 500 in the xy-plane will cause the frame 504 to move in a direction orthogonal to the motion of the resonating mass 502. The motion will change the distances between the sense fingers 512 and 514, causing a change in the capacitances between those fingers, from which the motion may be ascertained.

A damping stopper of a cap capping the MEMS device 500 is positioned to overlie resonating mass 502 and the space in the xy-plane between the resonating mass 502 and the frame 504. For example, a stopper 518 may have a perimeter as depicted by the dashed line superimposed over the illustrated MEMS substrate. In this manner, the stopper 518 damps the motion of the resonating mass 502 without substantially damping motion of the frame 504. As a result, the Q of the resonating mass 502 may be lowered, without lowering the Q of the frame. Thus, embodiments of the present application provide selective damping of one or more movable masses from among a plurality of masses of a MEMS device.

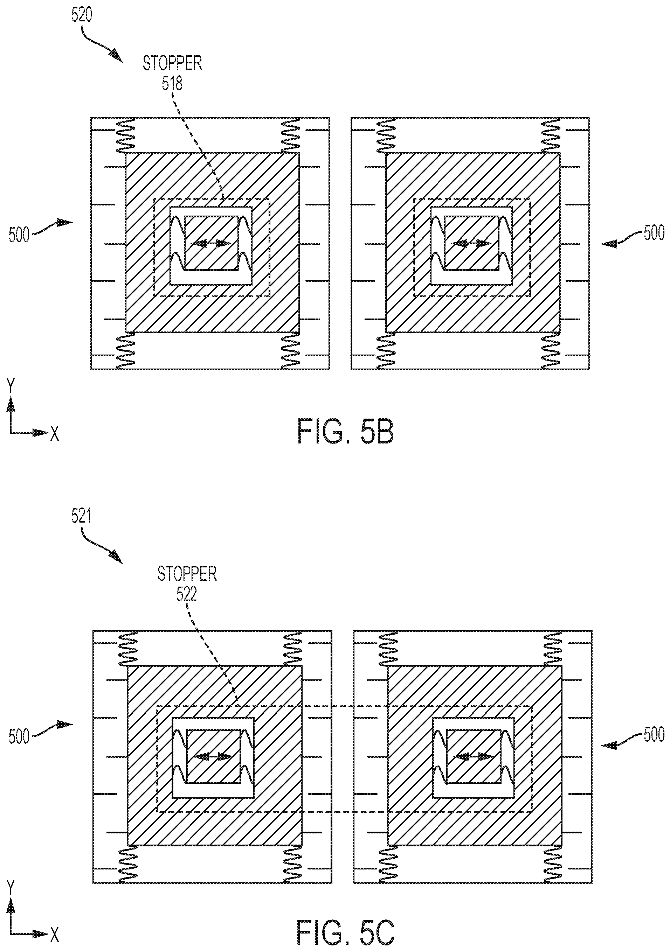

FIG. 5B illustrates another configuration in which selective damping may be achieved with damping stoppers of a cap for a MEMS device. The device 520 includes two copies of the MEMS device 500 of FIG. 5A, although the MEMS devices are rotated in the xy-plane in this illustration. The device 520 may represent a dual mass gyroscope.

FIG. 5C illustrates a variation on the device 520 of FIG. 5B, shown as device 521. In this configuration, instead of the respective stoppers 518 overlying the two proof masses, a single damping stopper 522 is provided overlying both resonating masses of the MEMS devices 500 as depicted by the dashed line representing a superposition of the stopper into the xy-plane of the resonating masses.

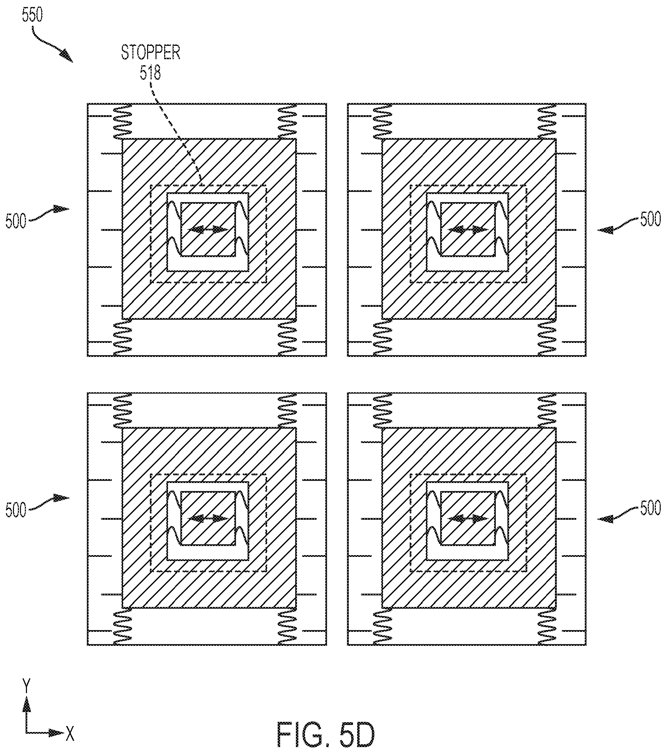

FIG. 5D illustrates a further embodiment, representing an extension of the device 520 of FIG. 5B to a quadruple mass device. The device 550 includes four replicas of the device 500 of FIG. 5A, although they are rotated in the x-y plane. As shown, respective stopper overlie the respective proof masses.

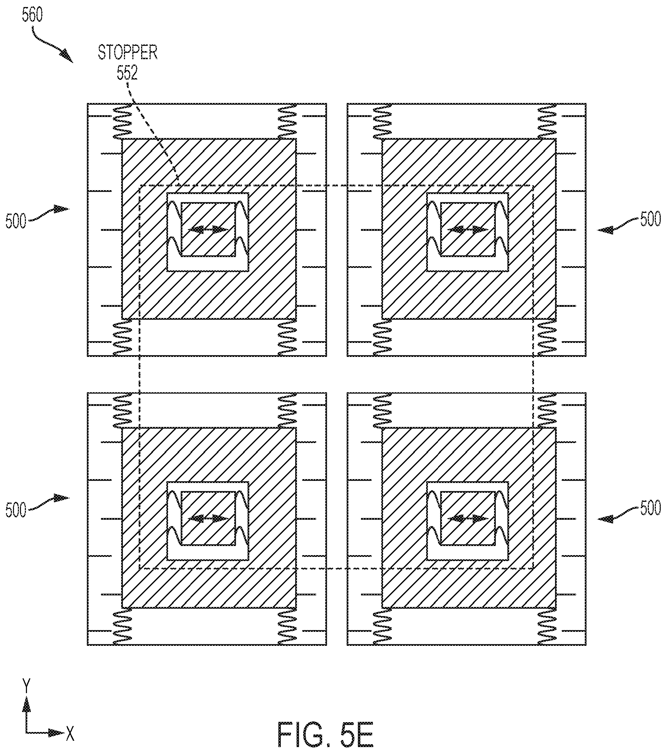

FIG. 5E illustrates a further configuration. In this non-limiting example, a MEMS device 560 is provided including four replicas of MEMS device 500. A damping stopper 552 is provided overlying the four resonating masses of the MEMS device 560 as depicted by the dashed line representing a superposition of the stopper into the xy-plane of the resonating masses. Thus, in some embodiments a quadruple mass gyroscope is provided with a damping stopper configured to damp in-plane motion of the resonating masses of the gyroscope.

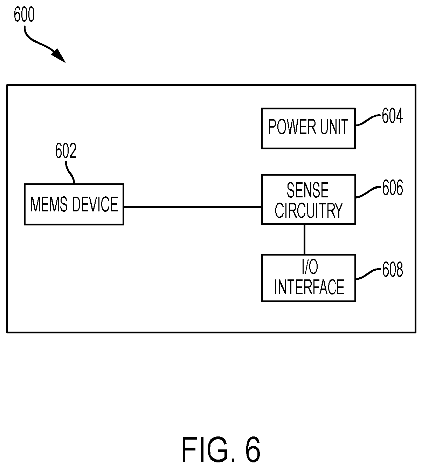

FIG. 6 illustrates an example of one type of system incorporating a MEMS device of the types described herein. The system 600 includes a capped MEMS device 602 having a damping stopper, read-out (or sense) circuitry 606, input/output (I/O) interface 608 and power unit 604. The MEMS device 602 may be any of the types described herein. The read-out circuitry 606 and I/O interface 608 may be an application specific integrated circuit (ASIC) with control functionality.

The read-out circuitry 606 may be configured to provide signals sensed by the MEMS device 602, such as acceleration or rotation signals. The signal(s) produced may be single-ended, while in other embodiments they may be differential. The read-out circuitry may include any suitable components for performing such read-out functions, as well as circuitry for signal processing functions such as filtering, amplifying, and demodulating. The read-out circuitry may comprise a trans-impedance amplifier in some embodiments. The read-out circuitry may be an application specific integrated circuit (ASIC) in some embodiments, and may be formed on a different substrate from the MEMS device, or on the same substrate in some embodiments.

In the system of FIG. 6, the read-out circuitry 606 is connected to I/O interface 608, which may serve as a communication interface through which the system 600 communicates with an external device, such as a remote computer or server. Thus, the I/O interface 608 may transmit the sensed signals outside system 600 for further processing and/or display. Additionally or alternatively, the I/O interface 608 may receive communications from an external device such as control signals, wireless charging signals, or software updates.

The I/O interface 608 may be wired or wireless. Suitable wired connections include Universal Serial Bus (USB) and Firewire connections, among others. In those embodiments in which a wired connection is used, the connection may be pluggable. Wired connections may be used in settings in which the system 600 is relatively immobile, for example when fixed on a substantially stationary object, or when the distance between system 600 and an external device with which it communicates remains relatively constant. In some embodiments, however, the I/O interface may be wireless, for example communicating via a flexible radio frequency (RF) antenna.

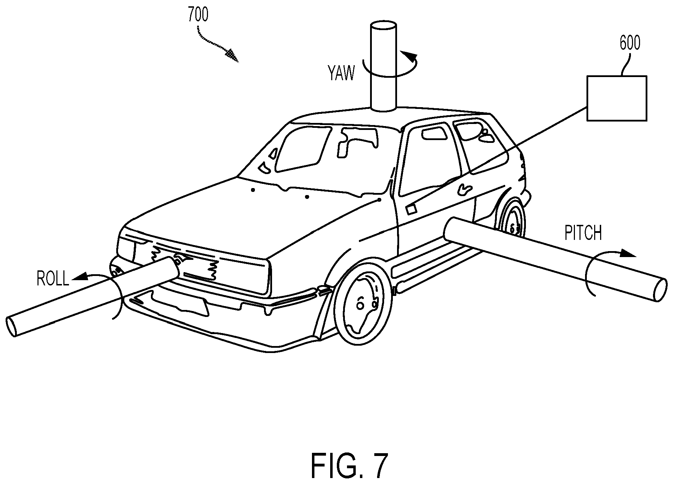

Another setting in which aspects of the present application may be implemented is in automobiles, or other vehicles, such as boats or aircrafts. FIG. 7 illustrates schematically a car 700 comprising the system 600 of FIG. 6. System 600 may be disposed in any suitable location of car 700. System 600 may be configured to sense roll, pitch and/or yaw angular rates. System 600 may be configured to provide, using I/O interface 608, sensed angular rates to a computer system disposed in car 700 and/or to a computer system disposed on a base station outside car 700. While FIG. 7 illustrates one example, other uses of the various aspects of the present application are possible.

The terms "approximately", "substantially," and "about" may be used to mean within ±20% of a target value in some embodiments, within ±10% of a target value in some embodiments, within ±5% of a target value in some embodiments, and yet within ±2% of a target value in some embodiments. The terms "approximately" and "about" may include the target value.

## Claims

1. A method of operating a microelectromechanical systems (MEMS) device (500) sealed in a cap (124) that comprises a first movable proof mass (502) and a second movable proof mass (504), the second movable proof mass (504) being concentric with and outside of the first movable proof mass (502) and configured to move in plane in a same plane as the first movable proof mass (502) and a stopper (518), the method comprising:
oscillating the first movable proof mass (502) of the MEMS device (500) in a first in-plane mode having a mode shape for changing a capacitance between a projection (512) coupled to the second movable proof mass (504) and a stationary projection (514) coupled to a substrate (508) of the MEMS device (500), wherein oscillating the first movable proof mass generates a gas flow; and
damping the motion of the first movable proof mass (502) in the first mode using the stopper (518) to impede the gas flow, wherein the stopper (518) is disposed out of the plane of motion of the first movable proof mass (518);
**characterised in that**:
the stopper (518) is shaped to overlie the first movable proof mass (502) and a space in the plane of movement of the first movable proof mass (502) between the first movable proof mass (502) and the second movable proof mass (504), and overlie internal edges of the second movable proof mass (504) and not to overlie outer edges of the second movable proof mass (504), to thereby damp the motion of the first movable proof mass (502) without substantially damping motion of the second movable proof mass (504).

2. The method of claim 1, further comprising moving the second movable proof mass (504) in-plane with the first movable proof mass (502) and orthogonal to oscillation of the first movable proof mass (502).

3. A MEMS device (500), comprising:
a first movable proof mass (502) and a second movable proof mass (504),
wherein the first movable proof mass (502) has an outer boundary adjacent an inner boundary of the second movable proof mass (504), the first movable proof mass (502) being configured to oscillate in a first plane mode having a mode shape for changing a capacitance between a projection (512) coupled to the second movable proof mass (504) and a stationary projection (514) coupled to a substrate (508) of the MEMS device (500), wherein oscillating the first movable proof mass (502) generates a gas flow;
and
a cap (124) covering the first movable proof mass (502), wherein the cap comprises a stopper (518) disposed out of the first plane, wherein the stopper (518) damps the movement of the first movable proof mass (502) in the first plane by impeding the gas flow, and **characterized in that**:
the stopper (518) overlies the first movable proof mass (502) and a space in the plane of movement of the first movable proof mass (502) between the outer boundary of the first movable proof mass (502) and the inner boundary of the second movable proof mass (504), and overlies internal edges of the second movable proof mass (504) and does not overlie outer edges of the second movable proof mass (504), to thereby damp the motion of the first movable proof mass (502) without substantially damping motion of the second movable proof mass (504).

4. The MEMS device of claim 3, further comprising an element that connects the first (502) and second (504) movable proof masses to each other; and wherein the second movable proof mass (504) is concentric with and outside of the first movable proof mass (502).

5. The MEMS device of claims 3 or 4, wherein the stopper (518) has a surface adjacent to and substantially parallel with the first movable proof mass (502).

6. The MEMS device of any of claims 3 to 5, comprising a third movable proof mass, wherein the stopper (518) covers greater than 50% of the third movable proof mass; and comprising fourth and fifth movable proof masses, wherein the stopper (518) covers greater than 50% of each of the fourth and fifth movable proof masses.

## Patentansprüche

1. Verfahren zum Betreiben einer Vorrichtung (500) von mikroelektromechanischen Systemen (MEMS), die in einer Kappe (124) versiegelt ist, die eine erste bewegliche Prüfmasse (502) und eine zweite bewegliche Prüfmasse (504) umfasst, wobei die zweite bewegliche Prüfmasse (504) konzentrisch zu und außerhalb der ersten beweglichen Prüfmasse (502) ist und so ausgebildet ist, dass sie sich in Ebene in einer gleichen Ebene wie die erste bewegliche Prüfmasse (502) und ein Stopfen (518) bewegt, wobei das Verfahren Folgendes umfasst:
Oszillieren der ersten beweglichen Prüfmasse (502) der MEMS-Vorrichtung (500) in einem ersten Modus in der Ebene, der eine Modusform aufweist zum Ändern einer Kapazität zwischen einer Projektion (512), die mit der zweiten beweglichen Prüfmasse (504) gekoppelt ist, und einer stationären Projektion (514), die mit einem Substrat (508) der MEMS-Vorrichtung (500) gekoppelt ist, wobei Oszillieren der ersten beweglichen Prüfmasse eine Gasströmung erzeugt; und
Dämpfen von Bewegung der ersten beweglichen Prüfmasse (502) im ersten Modus unter Verwendung des Stopfens (518), um die Gasströmung zu unterbinden, wobei der Stopfen (518) außerhalb der Bewegungsebene der ersten beweglichen Prüfmasse (518) angeordnet ist;
**dadurch gekennzeichnet, dass**:
der Stopfen (518) so geformt ist, dass er die erste bewegliche Prüfmasse (502) und einen Raum in der Bewegungsebene der ersten beweglichen Prüfmasse (502) zwischen der ersten beweglichen Prüfmasse (502) und der zweiten beweglichen Prüfmasse (504) überlagert, und Innenkanten der zweiten beweglichen Prüfmasse (504) überlagert und Außenkanten der zweiten beweglichen Prüfmasse (504) nicht überlagert, um dadurch die Bewegung der ersten beweglichen Prüfmasse (502) zu dämpfen, ohne im Wesentlichen Bewegung der zweiten beweglichen Prüfmasse (504) zu dämpfen.

2. Verfahren nach Anspruch 1, weiter umfassend Bewegen der zweiten beweglichen Prüfmasse (504) in der Ebene mit der ersten beweglichen Prüfmasse (502) und orthogonal zur Oszillation der ersten beweglichen Prüfmasse (502).

3. MEMS-Vorrichtung (500), umfassend:
eine erste bewegliche Prüfmasse (502) und eine zweite bewegliche Prüfmasse (504), wobei die erste bewegliche Prüfmasse (502) eine an eine Innengrenze der zweiten beweglichen Prüfmasse (504) angrenzende Außengrenze aufweist, wobei die erste bewegliche Prüfmasse (502) so ausgebildet ist, dass sie in einem Modus der ersten Ebene oszilliert, der eine Modusform aufweist zum Ändern einer Kapazität zwischen einer Projektion (512), die mit der zweiten beweglichen Prüfmasse (504) gekoppelt ist, und einer stationären Projektion (514), die mit einem Substrat (508) der MEMS-Vorrichtung (500) gekoppelt ist, wobei Oszillieren der ersten beweglichen Prüfmasse (502) eine Gasströmung erzeugt; und
eine Kappe (124), die die erste bewegliche Prüfmasse (502) abdeckt, wobei die Kappe einen Stopfen (518) umfasst, der außerhalb der ersten Ebene angeordnet ist, wobei der Stopfen (518) die Bewegung der ersten beweglichen Prüfmasse (502) in der ersten Ebene dadurch dämpft, dass sie die Gasströmung unterbindet, und **dadurch gekennzeichnet, dass**:
der Stopfen (518) die erste bewegliche Prüfmasse (502) und einen Raum in der Bewegungsebene der ersten beweglichen Prüfmasse (502) zwischen äußere Begrenzung der ersten beweglichen Prüfmasse (502) und der zweiten beweglichen Prüfmasse (504) überlagert, und Innenkanten der zweiten beweglichen Prüfmasse (504) überlagert und Außenkanten der zweiten beweglichen Prüfmasse (504) nicht überlagert, um dadurch die Bewegung der ersten beweglichen Prüfmasse (502) zu dämpfen, ohne im Wesentlichen Bewegung der zweiten beweglichen Prüfmasse (504) zu dämpfen.

4. MEMS-Vorrichtung nach Anspruch 3, weiter umfassend ein Element, das die erste (502) und zweite (504) bewegliche Prüfmasse miteinander verbindet; und wobei die zweite bewegliche Prüfmasse (504) konzentrisch mit und außerhalb der ersten beweglichen Prüfmasse (502) ist.

5. MEMS-Vorrichtung nach den Ansprüchen 3 oder 4, wobei der Stopfen (518) eine Oberfläche angrenzend und im Wesentlichen parallel zu der ersten beweglichen Prüfmasse (502) aufweist.

6. MEMS-Vorrichtung nach einem der Ansprüche 3 bis 5, umfassend eine dritte bewegliche Prüfmasse, wobei der Stopfen (518) mehr als 50 % der dritten beweglichen Prüfmasse abdeckt; und umfassend eine vierte und fünfte bewegliche Prüfmasse, wobei der Stopfen (518) mehr als 50 % von jeder der vierten und fünften beweglichen Prüfmasse abdeckt.

## Revendications

1. Procédé de fonctionnement d'un dispositif de systèmes microélectromécaniques (MEMS) (500) scellé dans un capot (124) qui comprend une première masse d'épreuve mobile (502) et une deuxième masse d'épreuve mobile (504), la deuxième masse d'épreuve mobile (504) étant concentrique à la première masse d'épreuve mobile (502) et à l'extérieur de celle-ci et conçue pour se déplacer dans le plan dans un même plan que la première masse d'épreuve mobile (502) et une butée (518), le procédé comprenant :
l'oscillation de la première masse d'épreuve mobile (502) du dispositif de MEMS (500) dans un premier mode dans le plan présentant une forme modale pour changer une capacité entre une projection (512) couplée à la deuxième masse d'épreuve mobile (504) et une projection fixe (514) couplée à un substrat (508) du dispositif de MEMS (500), dans lequel l'oscillation de la première masse d'épreuve mobile génère un flux de gaz ; et
l'amortissement du mouvement de la première masse d'épreuve mobile (502) dans le premier mode au moyen de la butée (518) pour entraver le flux de gaz, dans lequel la butée (518) est disposée hors du plan de mouvement de la première masse d'épreuve mobile (518) ;
**caractérisé en ce que** :
la butée (518) est façonnée pour surplomber la première masse d'épreuve mobile (502) et un espace dans le plan de mouvement de la première masse d'épreuve mobile (502) entre la première masse d'épreuve mobile (502) et la deuxième masse d'épreuve mobile (504), et surplomber des arêtes internes de la deuxième masse d'épreuve mobile (504) et ne pas surplomber des arêtes externes de la deuxième masse d'épreuve mobile (504), pour ainsi amortir le mouvement de la première masse d'épreuve mobile (502) sans amortir sensiblement le mouvement de la deuxième masse d'épreuve mobile (504).

2. Procédé selon la revendication 1, comprenant en outre le déplacement de la deuxième masse d'épreuve mobile (504) dans le plan avec la première masse d'épreuve mobile (502) et orthogonalement à l'oscillation de la première masse d'épreuve mobile (502).

3. Dispositif de MEMS (500), comprenant :
une première masse d'épreuve mobile (502) et une deuxième masse d'épreuve mobile (504), dans lequel la première masse d'épreuve mobile (502) présente un bord externe adjacent à un bord interne de la deuxième masse d'épreuve mobile (504), la première masse d'épreuve mobile (502) étant conçue pour osciller dans un mode de premier plan présentant une forme modale pour changer une capacité entre une projection (512) couplée à la deuxième masse d'épreuve mobile (504) et une projection fixe (514) couplée à un substrat (508) du dispositif de MEMS (500), dans lequel l'oscillation de la première masse d'épreuve mobile (502) génère un flux de gaz ; et
un capot (124) couvrant la première masse d'épreuve mobile (502), dans lequel le capot comprend une butée (518) disposée hors du premier plan, dans lequel la butée (518) amortit le mouvement de la première masse d'épreuve mobile (502) dans le premier plan en entravant le flux de gaz, et **caractérisé en ce que** :
la butée (518) surplombe la première masse d'épreuve mobile (502) et un espace dans le plan de mouvement de la première masse d'épreuve mobile (502) entre le bord externe de la première masse d'épreuve mobile (502) et le bord interne de la deuxième masse d'épreuve mobile (504), et surplombe des arêtes internes de la deuxième masse d'épreuve mobile (504) et ne surplombe pas des arêtes externes de la deuxième masse d'épreuve mobile (504), pour ainsi amortir le mouvement de la première masse d'épreuve mobile (502) sans amortir sensiblement le mouvement de la deuxième masse d'épreuve mobile (504).

4. Dispositif de MEMS selon la revendication 3, comprenant en outre un élément qui relie la première masse d'épreuve mobile (502) à la deuxième masse d'épreuve mobile (504) ; et dans lequel
la deuxième masse d'épreuve mobile (504) est concentrique à la première masse d'épreuve mobile (502) et à l'extérieur de celle-ci.

5. Dispositif de MEMS selon les revendications 3 ou 4, dans lequel la butée (518) présente une surface adjacente à la première masse d'épreuve mobile (502) et sensiblement parallèle à celle-ci.

6. Dispositif de MEMS selon l'une quelconque des revendications 3 à 5, comprenant une troisième masse d'épreuve mobile, dans lequel la butée (518) couvre plus de 50 % de la troisième masse d'épreuve mobile ; et comprenant des quatrième et cinquième masses d'épreuve mobiles, dans lequel la butée (518) couvre plus de 50 % de chacune des quatrième et cinquième masses d'épreuve mobiles.
